# EUROPEAN PATENT APPLICATION

(11) **EP 1 909 333 A1**
(43) Date of publication of application: **09.04.2008**
(21) Application number: 06781962.3
(22) Date of filing: 28.07.2006
(51) Int. Cl.: H01L 31/042, H01L 31/04

(54) **SOLAR CELL MODULE**

(30) Priority: 28.07.2005 JP 2005218536; 27.10.2005 JP 2005313190; 01.12.2005 JP 2005347523
(71) Applicant: Kyocera Corporation, Kyoto-shi, Kyoto-fu 612-8501 (JP)
(72) Inventor: MORITA, Hiroshi c/o KYOCERA Corporation,, Ise-city, Mie 5168510 (JP); NAGATA, Masaru c/o KYOCERA Corporation, Kyoto 6190237 (JP); YASHIKI, Tatsuya c/o KYOCERA Corporation,, Ise-city, Mie 5168510 (JP)
(74) Representative: Steil, Christian
(86) International application number: PCT/JP2006/315052
(87) International publication number: WO 2007/013625

(57) **Abstract**

Superior yield is achieved by eliminating the occurrence of cracks after connecting together solar cells by soldering on connecting conductors so as to provide highly reliable connecting conductors and solar cell modules. The solar cell modules have solar cells formed with electrodes and ribbon-shaped connecting conductors connecting with the electrodes using solder. The plane shape of at least one end of the connecting conductors is provided with a plurality of angled sections with obtuse angles.

## Description

### TECHNICAL FIELD

The present invention relates to a solar cell module.

### BACKGROUND ART

Typically, solar cell modules are formed by connecting a number of solar cells where electrodes are formed on both main surfaces of a monocrystalline silicon substrate or polycrystalline silicon substrate constituting a PN junction using connecting conductors. Mutually connected solar cells are then encapsulated between a transparent substrate and a back sheet and coated with a filler having, for example, an ethylene vinyl acetate (EVA) copolymer as a main constituent. Solar cells are electrically connected together by soldering light-receiving surface-side electrodes and reverse side electrodes of the solar cells using ribbon-shaped connecting conductors.

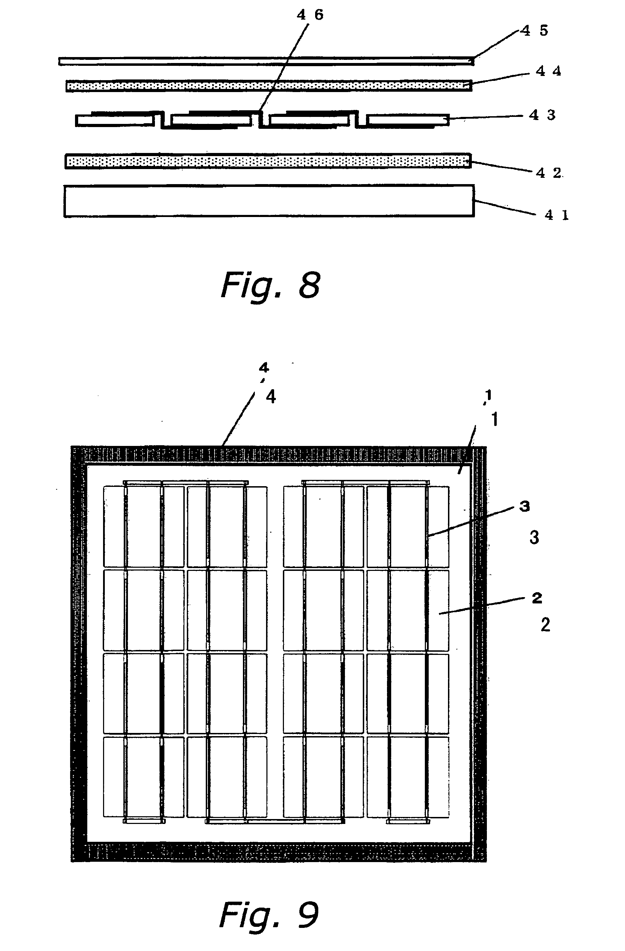

Fig. 9 is a view showing an example of the external appearance of a light-receiving surface-side of a solar cell module of the related art. In the drawing, numeral 1 denotes a transparent substrate, numeral 2 denotes a solar cell, numeral 3 denotes a connecting conductor, and numeral 4 denotes a module frame.

The solar cell module is electrically connected by the connecting conductor 3 between the transparent substrate 1 and a rear sheet (not shown) as described above. The solar cells 2 are enclosed using filling. The module frame 4 is fitted to the outer periphery.

This solar cell module is connected to electrodes of the solar cells 2 as a result of soldering etc. the connecting conductor 3 (for example, refer to patent document 1).

Patent Document 1: Japanese Laid-open Patent Publication No. 2004-281797

### DISCLOSURE OF INVENTION

### Problems to be Solved by the Invention

With the kind of solar cell module described above, when temperature changes occur as a result of the daily temperature cycle etc., the connecting conductor expands or contracts. Solar cells connected to the connecting conductor are then unable to absorb stress occurring as a result of the expansion etc. of the connecting conductor. There is therefore the fear of cracks occurring in the semiconductor substrate as a result. In particular, regarding the connecting region for the connecting conductor and electrodes, at the ends of the connecting conductor, the amount of thermal expansion (thermal contraction) of the connecting conductor is substantial and it is therefore easy for cracks to occur in the solar cells.

In order to resolve the problems described above, the object of the present invention is to provide a solar cell module capable of suppressing the occurrence of cracks in the solar cells.

### Means for Solving the Problem

In order to achieve the above object, a solar cell module of a first embodiment of the present invention includes solar cells formed with electrodes and ribbon-shaped connecting conductors connected to the electrodes using solder. A plane shape of at least one end of the connecting conductors has a plurality of angled sections with obtuse angles.

A solar cell module of a further embodiment of the present invention includes solar cells formed with electrodes and ribbon-shaped connecting conductors connected to the electrodes using solder. A plane shape of at least one end of the connecting conductors includes a peripheral edge made from a curve extending outwards.

### The curve can be a circular arc.

A solar cell module of a still further embodiment of the present invention includes solar cells formed with electrodes and ribbon-shaped connecting conductors connected to the electrodes using solder. The connecting conductors can have a through-hole at at least one end.

The end(s) can be thinner than other portions of the connecting conductors.

Here, the end(s) can be thinner than other portion of the connecting conductors.

### BRIEF DESCRIPTION OF DRAWINGS

Fig. 1 shows an example of the external appearance of a solar cell used in a solar cell module of the present invention;
Fig. 2 shows an example of the external appearance of a connecting conductor of the present invention;
Fig. 3 is an enlarged view of an end part of a connecting conductor of the present invention;
Fig. 4 shows a state after soldering a connecting conductor to a bus bar electrode of a solar cell of the present invention;
Fig. 5 is an enlarged view of an end part of a further embodiment of a connecting conductor of the present invention;
Fig. 6 is an enlarged view of an end part of another embodiment of a connecting conductor of the present invention;
Fig. 7 is an enlarged view of an end part of a still further embodiment of a connecting conductor of the present invention;
Fig. 8 is a view showing an example structure for a solar cell module of the present invention;
Fig. 9 is a view showing an example of the external appearance of a light-receiving surface-side of a solar cell module of a related art.

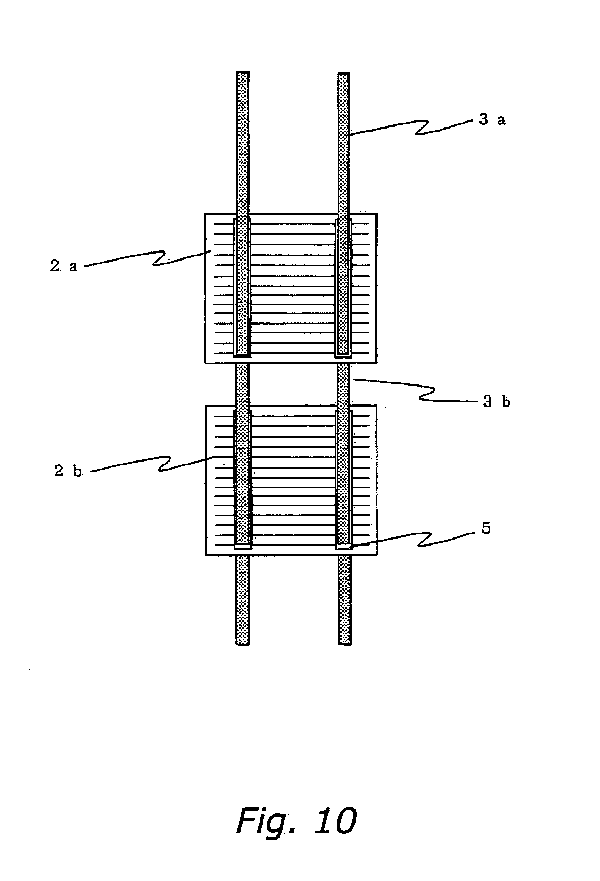

Fig. 10 shows an example of a state where two solar cells are connected in series using a connecting conductor of the related art;
Fig. 11 shows an example of apparatus connecting the connecting conductor to the solar cells;

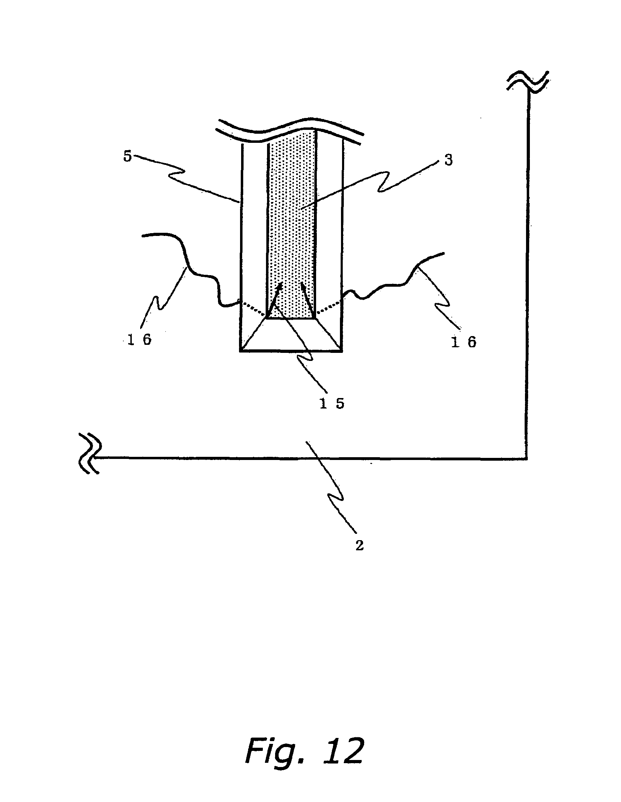

Fig. 12 shows a state where a connecting conductor of the related art is soldered onto a bus bar electrode of a solar cell of the present invention;
Fig. 13 shows an example of the external appearance of another embodiment of the connecting conductor of the present invention;
Fig. 14 is an enlarged view of an end part of a further embodiment of a connecting conductor of the present invention;
Fig. 15 is an enlarged view of an end part of a still further embodiment of a connecting conductor of the present invention;
Fig. 16 is an enlarged view of an end part of another embodiment of a connecting conductor of the present invention;
Fig. 17 shows an example of solar cell module producing apparatus of the present invention where connecting conductors are soldered to solar cells;
Fig. 18 shows a further example of solar cell module producing apparatus of the present invention where connecting conductors are soldered to solar cells;
Fig. 19 shows a still further example of solar cell module producing apparatus of the present invention where connecting conductors are soldered to solar cells; and
Fig. 20 shows another example of solar cell module producing apparatus of the present invention where connecting conductors are soldered to solar cells.

### BEST MODE FOR CARRYING OUT THE INVENTION

The following is a detailed description of embodiments of the present invention using the appended drawings.

In the present invention, "end of the connecting conductor" is taken to mean a region spanning half or less of the longitudinal direction, from a part having maximum width to a tip. When a part having maximum width continues for a predetermined length, a region from a part closest to this tip to the tip constitutes the end.

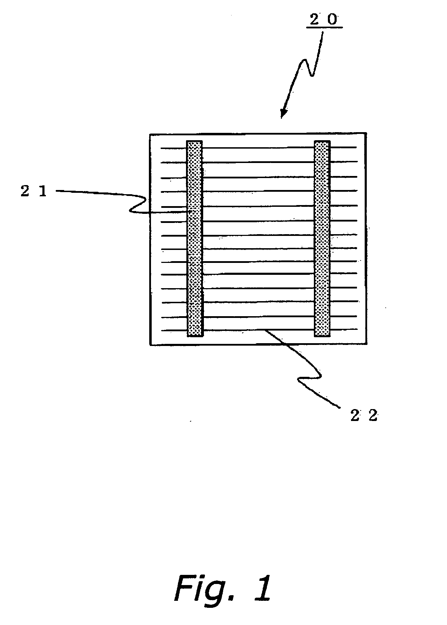

Fig. 1 shows an example of the external appearance of a solar cell used in a solar cell module of the present invention.

In Fig. 1, numeral 20 indicates a solar cell, numeral 21 indicates bus bar electrodes for the solar cell, and numeral 22 indicates finger electrodes.

The solar cell 20 includes a monocrystalline silicon substrate or polycrystalline silicon substrate that is, for example, 0.3 to 0.4 mm thick and is a square with sides 150 mm long. A PN junction (not shown) is then formed as a result of connecting a P-type layer containing a large amount of P-type impurity such as Boron and an N-type layer containing a large amount of N-type impurity such as phosphorus at the silicon substrate of the solar cell 20. The bus bar electrodes 21 and finger electrodes 22 are also formed at the surface of the solar cell 20.

The bus bar electrodes 21 and finger electrodes 22 are formed by printing and baking of silver paste etc., and substantially the whole of the surface of the bus bar electrodes 21 can be coated with solder. Further, a multiplicity of finger electrodes 22 are formed 0.1 to 0.2 mm wide parallel with a predetermined side of the solar cell in order to collect light-generating carriers. Moreover, two to three bus bar electrodes 21 are formed intersecting the finger electrodes 22 at right-angles at widths of 2 mm in order to focus collected carriers and mount the connecting conductor. The bus bar electrodes 21 and the finger electrodes 22 are similarly formed at the rear surface (non-light-receiving surface) of the solar cell 20.

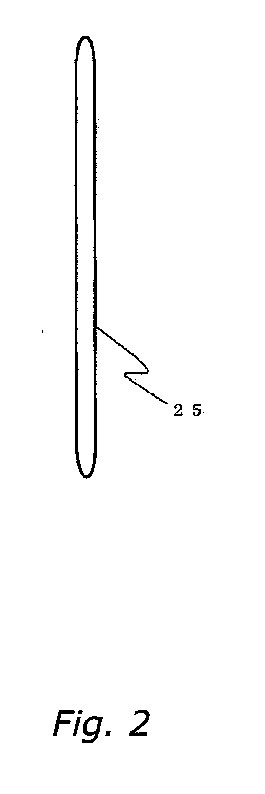

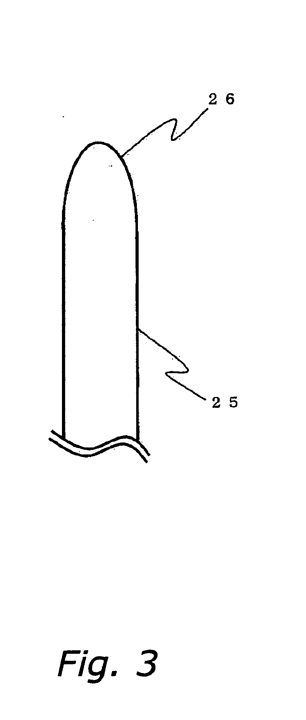

Fig. 2 is a view showing an example of the external appearance of the connecting conductor of the present invention, and Fig. 3 is an enlarged view of an end.

A connecting conductor 25 of the present invention connected to the electrodes of the solar cell is in the order of 0.1 to 1.0 mm thick and is of a width that is the same as or less than the width of the bus bar electrodes 21 so that the connecting conductor 25 of the solar cell 20 does not itself cast shadows on the light receiving surface of the solar cell 20. The lengths of connecting conductors 23 substantially overlap with the whole of the bus bar electrodes 21, and further overlap with and connect to rear surface-side bus bar electrodes (not shown) of solar cells neighboring the solar cells at predetermined intervals. When a typical solar cell having a 150 mm-sided polycrystalline silicon substrate is used, the connecting conductors 25 are 1 to 3 mm wide and 200 to 300 mm long. The connecting conductors 25 are made to overlap with substantially the whole of the light-receiving surface-side bus bar electrodes 21 in order to make an electrical resistance component small.

Further, the material for the connecting conductors 25 can comprise a metal material with superior conductivity such as silver, copper, aluminium, or iron, with copper foil being suitable taking into consideration conductivity and ease of coating with solder, etc. The entire surface of the connecting conductors can also be coated with solder in order to make soldering to the bus bar electrodes 21 of the solar cells 20 straightforward. This is achieved by covering one side of the copper foil etc. with in the order of 20 to 70 microns of solder by dipping the copper foil in a solder bath or by plating the copper foil.

### (End shape 1 for the connecting conductor)

Further, as shown in the example of the present invention shown in Figs 2 and 3, the connecting conductors 25 of the present invention include a peripheral edge 26 at at least one end constructed in the shape of a curve extending outwards. The peripheral edge 26 formed from a curve in this manner can be made by die-cutting processing using a die of a predetermined shape when the connecting conductors 25 are cut to an appropriate length as described above.

Further, the connecting conductors 25 are also soldered to the bus bar electrodes 21 of the rear surface side of another solar cell connected to the bus bar electrodes 21 of the light-receiving surface-side of the solar cell 20. This kind of peripheral edge 26 of the end(s) of the connecting conductors 25 is therefore preferably provided on both sides. However, in the event that one of the light-receiving surface-side or rear surface side bus bar electrodes is strongly bonded with the silicon substrate but the other is weakly bonded as a result of differences in solar cell manufacturing methods, just the end side of the connecting conductor 25 soldered to the side of the weakly joined bus bar electrode of the connecting conductor can be taken to have the curved peripheral edge 26.

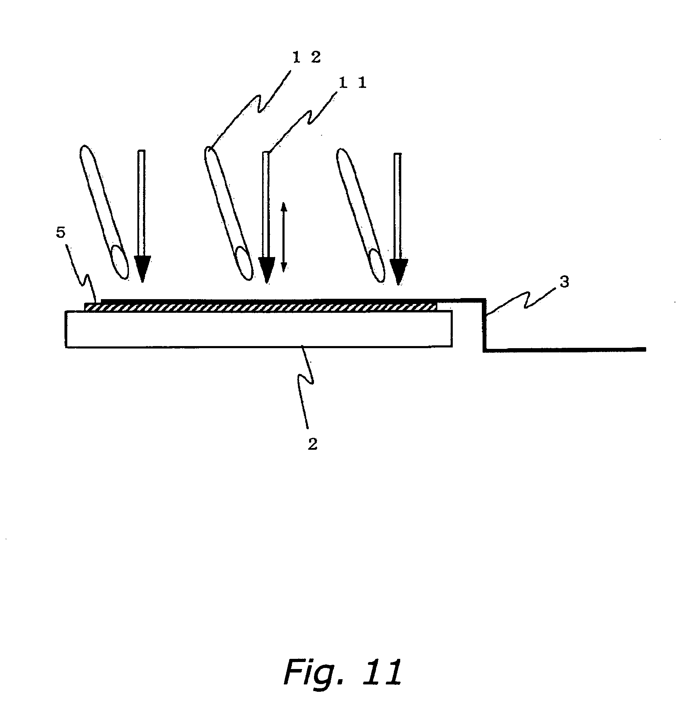

The connecting conductors 25 are arranged on the bus bar electrodes 21 of the solar cell 20 so that, for example, as shown in Fig. 11, the connecting conductors 25 are soldered to the bus bar electrodes 21 by spouting hot air from a nozzle while pressing down using pressing pins 11.

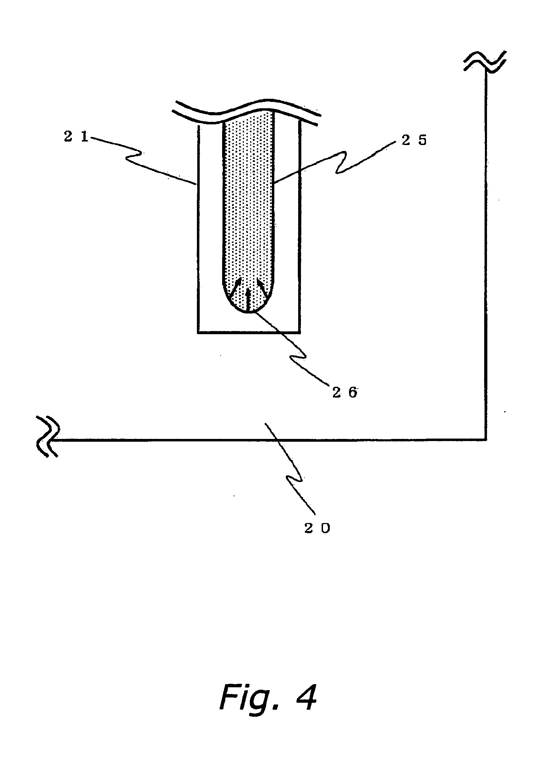

Fig. 4 shows a state where the connecting conductor 25 of the present invention are soldered to the bus bar electrodes 21 of the solar cells 20.

When a solar cell module is installed outdoors, or even when changes in temperature occur at the solar cells and connecting conductors in a solar cell module manufacturing process, the connecting conductors 25 of the present invention are such that a plane shape of at least one end includes a peripheral edge in the shape of a curve that extends outwards. It is therefore possible for stress occurring as a result of differences in the thermal expansion coefficients between the connecting conductors 25 and the semiconductor substrate to be distributed at the peripheral edge of these ends.

As a result, after soldering the connecting conductor 25, it is possible to suppress the occurrence of cracks in the solar cells as a result of the concentration of stress due to contraction and it is possible to suppress peeling of the bus bar electrodes 21 from the silicon substrate after soldering of the connecting conductors 25.

Further, it is preferable for the curve with which the peripheral edge of the end extends outwards described above to be a circular arc. Uniform distribution of stress applied to the ends of the connecting conductors becomes more straightforward as a result of adopting a circular arc.

### (End shape 2 for the connecting conductor)

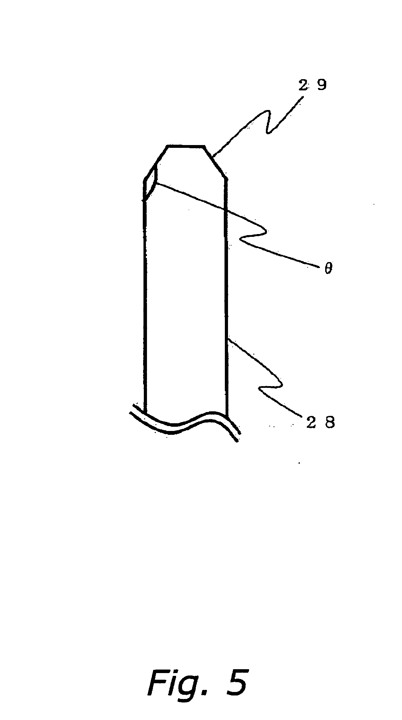

Further, as shown in Fig. 5, it is possible to provide the plane shape of at least one of the ends of a connecting conductor 28 with a plurality of angled sections having obtuse angles. In this case, after cutting a member for the ribbon-shaped connecting conductor 28 approximately at right-angles, the obtuse angle sections can be formed by cutting off substantially right-angled portions of the connecting conductor. A plurality of inclined sides 29 are then formed at the end(s) of the connecting conductors 28 as shown in Fig. 5.

When a solar cell module is installed outdoors, or even when changes in temperature occur at the solar cells and connecting conductors in a solar cell module manufacturing process, the connecting conductors 25 of the present invention are such that a plane shape of at least one end is provided with a plurality of angled sections having obtuse angles. It is therefore possible for stress occurring as a result of differences in the thermal expansion coefficients between the connecting conductors 25 and the semiconductor substrate to be distributed at the peripheral edge(s) of the end(s).

As a result, after soldering the connecting conductors 25, it is possible to suppress the occurrence of cracks in the solar cells as a result of the concentration of stress due to contraction and it is possible to suppress peeling of the bus bar electrodes 21 from the silicon substrate after soldering of the connecting conductors 25.

The plane shapes of the ends are formed with a plurality of angled sections having obtuse angles, by simply chopping off right-angled portions of current connecting conductors. This means that the design and preparation of a mold for punching etc. is not necessary and the present invention can therefore be implemented in a cheap and straightforward manner.

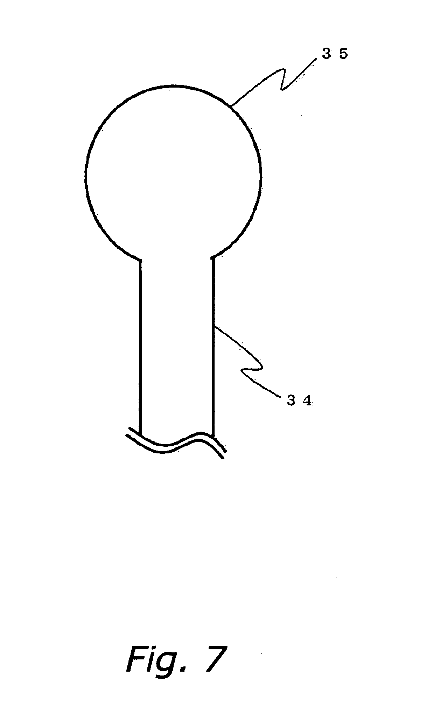

Moreover, it is also possible to adopt a circular shape having a larger diameter than the width of a connecting conductor 34 at an end 35 of the connecting conductor 34 as shown in Fig. 7. In this case, the end of the connecting conductor 34 can be formed into a predetermined shape such as, for example, a large circle, by punching after the end of the connecting conductor 34 is extended to become thin by pressing etc.

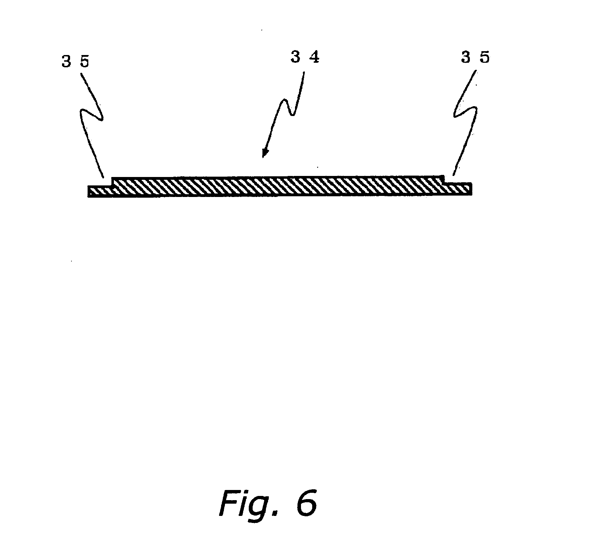

At this time, as shown in Fig. 6, the thickness of the end 35 of the connecting conductor 34 can be formed thinner than other portions of the connecting conductor 34. Stress occurring at the end 35 of the connecting conductor 34 can be weakened and the occurrence of cracks can be reduced as a result of adopting this kind of structure.

A feature of this end is being formed thin as a result of pressing force. The end of the connecting conductor is then rolled out so as to be formed in an integrated manner. This is preferable from an electrical and mechanical point of view.

### (End shape 3 for the connecting conductor)

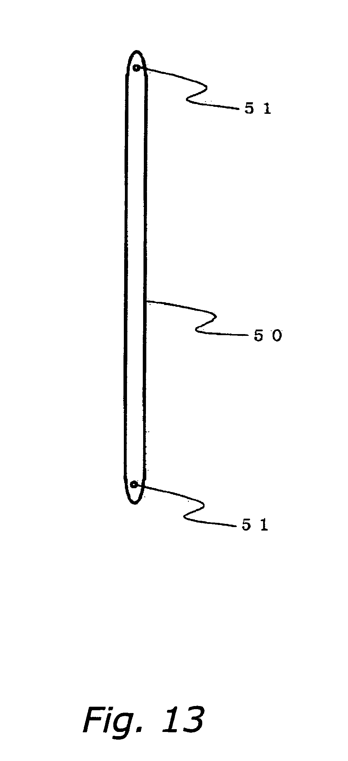

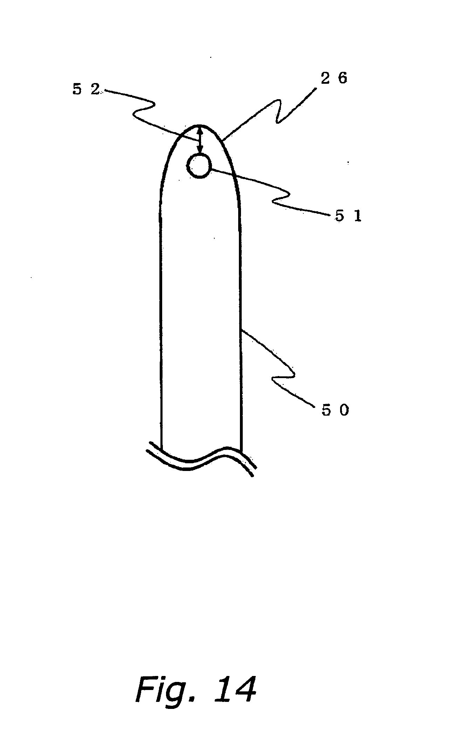

Figs 13 and 14 show a further embodiment of a connecting conductor of the present invention, where Fig. 13 is an overall view and Fig. 14 is an enlarged view of an end.

A connecting conductor 50 of the present invention as shown in Fig. 13 is provided with a through-hole 51 at at least one end.

The through-hole 51 is made by punching and can be circular or elliptical, or can be a polygonal shape such as a quadrangle, hexagon, or octagon. In the case of, for example, a circle, this size may be such that the diameter is one-third to two-thirds of the width of the connecting conductor 50. Further, the through-hole 51 is positioned at substantially the center of the width of the connecting conductor 50, with a distance 52 from an end surface of the connecting conductor 50 to the through-hole 51 being in the order of 1 to 5 mm.

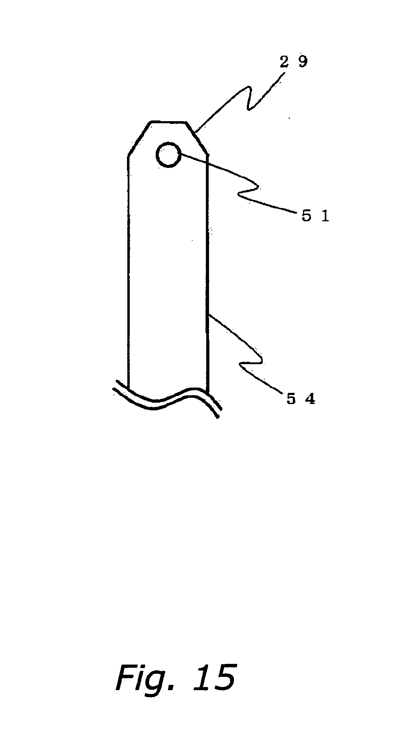

Moreover, as shown in Fig. 15, by providing the inclined sides 29 at the ends of a connecting conductor 54, it is possible to make the shape of the ends a polygonal shape equipped with a plurality of angled sections having obtuse angles and having the through-hole 51. Further, as shown in Fig. 14, the end shape of the connecting conductor 50 can also have the peripheral edge 26 made from a curve extending outwards while also being provided with the through-hole 51.

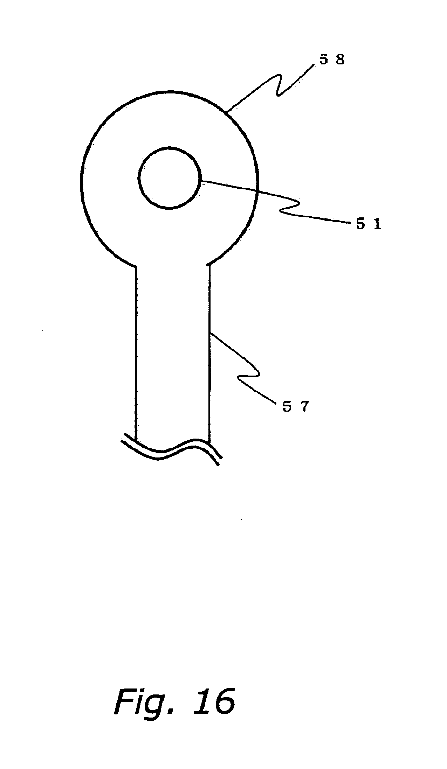

Still further, as shown in Fig. 16, after an end 58 of a connecting conductor 57 is extended by pressing etc. so as to be made thin, after then punching into a substantially round shape, a structure provided with the through-hole 51 is possible.

A structure is also possible where this kind of through-hole 51 is provided on either one side in cases where there are differences in the magnitude of stress generated at the light-receiving surface-side and rear surface side of the soldered solar cell.

It is possible to reduce stress due to thermal contraction of the connecting conductors in a direction inwards from the ends by providing a through-hole at at least one end of the connecting conductors. It is then possible to reduce the occurrence of cracks in the solar cell.

Solar cells are then connected together electrically using the connecting conductors made in this manner so as to make a solar cell module.

Fig. 8 is a view showing an example structure for a solar cell module of the present invention.

In Fig. 8, numeral 41 denotes a transparent substrate, numeral 42 denotes a light-receiving surface-side filler, numeral 43 denotes a solar cell, numeral 44 denotes a rear surface side filler, numeral 45 denotes a rear surface sheet, and numeral 46 denotes the connecting conductor of the present invention.

The following is a description of each member.

A substrate made of glass or polycarbonate resin etc. can be used as the transparent substrate 41. White glass, toughened glass, multiply toughened glass or heat-reflecting glass etc. can be used as the glass plate, with white toughened glass of a thickness of 3 mm to 5 mm typically being employed. On the other hand, when a substrate comprised of composite resin such as a polycarbonate resin etc. is employed, plates of a thickness in the order of 5 mm are commonly used.

The light-receiving surface-side filler 42 and the rear surface-side filler 44 are comprised of ethylene vinyl acetate copolymer (hereinafter abbreviated to EVA) or polyvinylbutyral (PVB), and items formed in sheets to a thickness in the order of 0.4 to 1 mm by a T-die and extruder can be employed. The light-receiving surface-side filler 42 and the rear surface-side filler 44 are made soft and flexible in order to be integrated with other members by applying heat and pressure under reduced pressure using laminating apparatus.

EVA and PVB contain titanium oxide and pigment etc. and can be colored white at the light-receiving surface-side filler 42 occurring in the solar cell module manufacturing method of the present invention. However, this coloring reduces the amount of light incident to the solar cells 43 and the efficiency with which electricity is generated therefore falls, and transparent filler is therefore adopted.

Further, the EVA and PVB used at the rear surface-side filler 44 can be transparent or can also contain titanium oxide or pigment etc. so as to be colored white etc. in line with the surrounding installation environment the solar cell module is installed in.

A weatherproofed fluorine family resin sheet sandwiching aluminum foil so that moisture cannot permeate, or a polyethylene terephthalate (PET) sheet etc. deposited with alumina or silica can be used as the rear surface sheet 45.

Next, a method for manufacturing a solar cell module is described.

The light-receiving surface-side filler 42, solar cell module, rear surface-side filler 44, and rear surface sheet 45 are sequentially stacked one on top of another on the transparent substrate 41 in order to give the solar cell module the desired strength. This assembly is then integrated by installing in a laminator in this state, and heating for, for example, fifteen minutes to one hour at a temperature of 100 to 200 degrees centigrade while pressing under low pressure. After this, a module frame is fitted to the outer periphery of the solar cell module so as to give a solar cell module having the desired strength.

The present invention is by no means limited to the above embodiments, and many amendments and modifications can be applied within the scope of the present invention. For example, the solar cells are by no means limited to being crystal solar cells such as monocrystalline or polycrystalline silicon and application to thin-film solar cells etc. is also possible.

Further, implementation is also possible with lead-free solder in addition to eutectic solder of tin and lead as the solder used in the soldering.

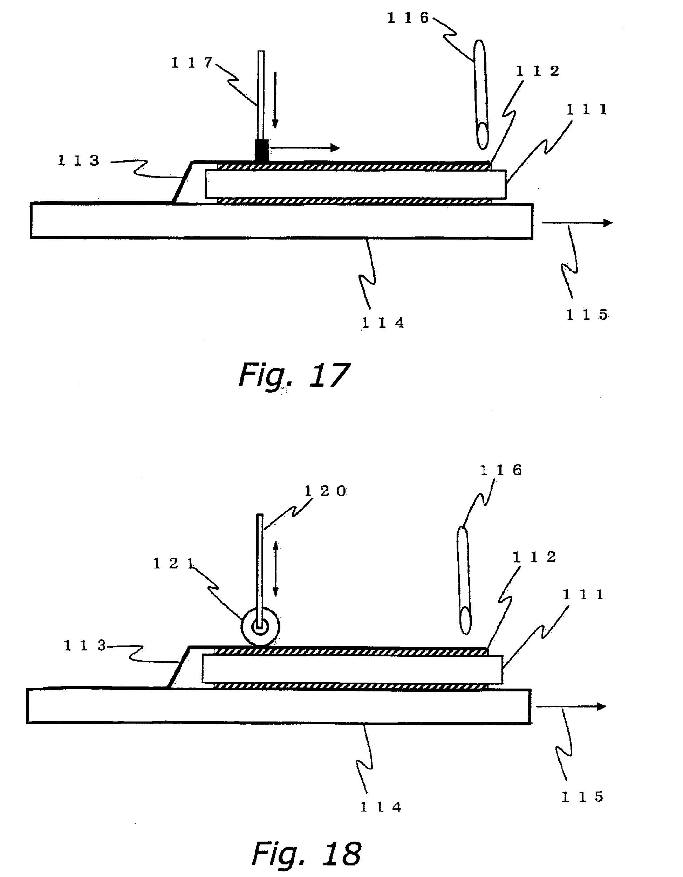

Fig. 17 shows an example of a solar cell module producing apparatus of the present invention where connecting conductors are soldered to solar cells. In Fig. 17, numeral 111 denotes a solar cell, numeral 112 denotes a bus bar electrode, numeral 113 denotes a connecting conductor, numeral 114 denotes an work stage, numeral 115 denotes an work stage moving direction, numeral 116 denotes a hot air blast blowing nozzle, and numeral 117 denotes a pressing pin.

The solar cell 111 is made using monocrystalline or polycrystalline silicon as described above, and the bus bar electrode 112 is formed on the light-receiving surface-side and the rear surface side.

The connecting conductor 113 is formed in a ribbon-shape from a metal foil of superior conductivity which is then coated with solder and cut to an appropriate length. It is then desirable to adopt a structure as described above where a plane shape of at least one end of the connecting conductor is given a plurality of angled sections that are obtuse angles, or a structure including a peripheral edge formed in a curve extending outwards, with a through-hole further being provided at at least one end.

The work stage 114 is made using stainless steel 5 to 10 mm thick and is preferably provided with a pin for positioning the solar cell 111 and a through-hole etc. for vapor deposition for ensuring that the solar cell does not move after positioning. Further, the work stage 114 has a mechanism for being moved in a straight line in a direction of the arrow 115 at a fixed speed by a servo motor etc.

The hot air blast blowing nozzle 116 is made using a metal pipe of stainless steel etc. of a diameter of 2 to 5 mm, with one end facing in the direction of the bus bar electrodes, and the other end connected to a hot air blower (not shown). Further, a solenoid valve etc. is provided midway along this pipe so that means can be provided for controlling the duration and timing of the blowing of hot air by opening and closing the solenoid valve using a signal from a sequencer, etc. Moreover, a temperature sensor such as a thermocouple is provided in the vicinity of the tip of the hot air blast blowing nozzle 116. Control is then exerted so that the temperature of the hot air automatically becomes the set temperature as a result of the temperature controller.

Approximately one to three hot air blast blowing nozzles 116 of the present invention are provided at fixed positions above the ends of the bus bar electrodes 112.

The pressing pin 117 of the present invention is a columnar pressing member fitted to a metal shaft of stainless steel etc. approximately 50 to 100 mm long and 1 to 3 mm in diameter. The columnar pressing member is approximately 2 to 5 mm in diameter and 4 to 6 mm high and the material used is preferably nickel-plated carbon tool steel. The pressing pin 117 is driven in a vertical direction by a drive system so that the connecting conductors 113 are pushed against the bus bar electrodes 112 at a pressure that is always fixed by a spring etc.

Further, the pressing pin 117 of the present invention also has a similarly operating mechanism that causes synchronous movement of the work stage 114 at a fixed speed.

Fitting of the connecting conductors 113 to the bus bar electrodes 112 on the solar cell 111 in the solar cell module manufacturing apparatus of the present invention is carried out as follows.

First, a connecting conductor 113 to be fitted is brought onto the bus bar electrode 112 of the solar cell 111. The pressing pin 117 is then lowered, and the connecting conductor 113 is pressed onto the bus bar electrode 112. Hot air of a temperature of approximately 400 to 500 degrees centigrade is then blown from the hot air blast blowing nozzle 116 onto one end of the bus bar electrode 112 the connecting conductor 113 is mounted on. Solder on the bus bar electrode 112 of the solar cell 111 and solder of the connecting conductor 113 then becomes molten. The work stage 114 is then moved in the direction of the arrow 115 as far as the other end of the bus bar electrode 112 while blowing hot air so that the position of the molten solder is gradually moved. The blowing of hot air is then stopped and the pressing pin 117 is raised once the solder solidifies.

As described above, with solar cell module manufacturing apparatus for fitting connecting conductors 113 for electrically connecting the solar cells 111 to bus bar electrodes 112 of the solar cells 111 by soldering, a hot air blast blowing nozzle 116 for soldering is fixed at the upper part of one end of the bus bar electrodes 112 of the solar cells 111. That with the connecting conductor 113 mounted on the bus bar electrode 112 of the solar cell 111 is then moved from one end of the bus bar electrode 112 of the solar cell 111 to the other end while blowing hot air from the hot air blast blowing nozzle 116. This means that compared to up until now where the connecting conductors 113 on the electrodes have been soldered at substantially the same time over the whole of this region, portions to be soldered are consecutively moved from one end of the bus bar electrodes 112 of the solar cell to the other end. It is therefore possible for differences in the extent of thermal contraction due to differences in thermal expansion coefficients of the materials for the solar cells 111 and the connecting conductors 113 when heating using hot air at the time of soldering to be absorbed by portions that have not been soldered. Warping therefore no longer occurs at the solar cell 111 after fitting of the connecting conductors 113, and peeling of the electrodes of the solar cells 111 from the solar cell substrate, fracturing and cracking no longer occurs for the solar cells 111 in subsequent solar cell module processes.

Further, it is apparent from tests repeatedly carried out by the inventors that the speed of movement of the work stage 114 in the direction of the arrow 115 is preferably 15 mm per second or less.

Namely, a soldering speed exceeding 15 mm per second means that absorption of differences in the amount of thermal contraction due to differences in thermal expansion coefficients by portions that are not soldered is insufficient. It is therefore not possible to completely prevent warping of the solar cells.

Fig. 18 shows a further example of solar cell module producing apparatus of the present invention where connecting conductors are soldered to solar cells. In Fig. 18, a pressing pin 120 is a plate made from a metal such as stainless steel that is approximately 50 to 100 mm long and approximately 1 to 3 mm wide and separates into two on the side of the solar cells 111. A roller 121 made of metal is then fitted there between in a freely rotating manner using a shaft. Stainless steel or nickel-plated carbon steel is preferably used as the material for the roller. Further, the roller 121 is convex in shape in such a manner that both ends protrude by approximately 0.5 to 1.0 mm compared to the center in a width direction. This is because it is preferable to prevent the connecting conductor 113 from meandering.

The pressing pin 120 is driven in a vertical direction by a drive system so that the connecting conductors 113 are pushed against the bus bar electrodes 112 at a pressure that is always fixed by a spring etc.

As a result of doing this, when the work stage 114 is moved in the direction of the arrow 115 from an end of the bus bar electrode 112 to the other end while blowing hot air from the hot air blast blowing nozzle 116 so that the position of the molten solder is gradually moved, it is no longer necessary to synchronously move the work stage 114 because the roller 121 of the pressing pin 120 rotates. This means it is possible to simplify the structure of the apparatus.

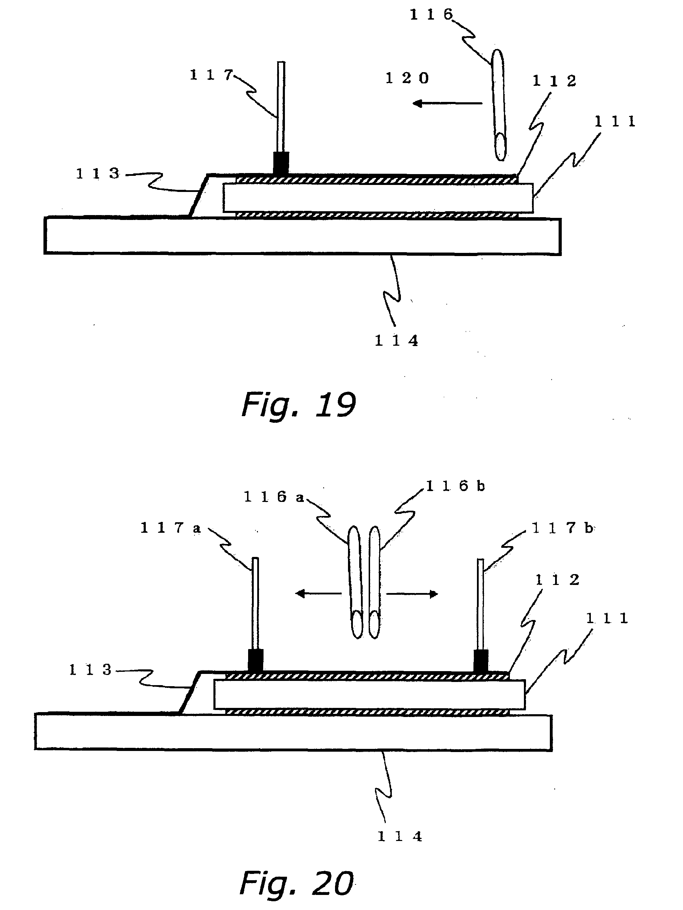

Fig. 19 shows a further example of solar cell module producing apparatus of the present invention where connecting conductors are soldered to a solar cell.

In Fig. 19, the work stage 114 is fixed and the mechanism is such that the hot air blast blowing nozzle 116 is moved by a servo motor etc. in a rectilinear manner at a fixed speed in the direction of the arrow 120 from an end of the bus bar electrodes 112 of the solar cell 111 to the other end while blowing hot air.

Namely, with solar cell manufacturing apparatus for fitting the connecting conductors 113 for electrically connecting the solar cell 111 to the bus bar electrodes 112 of the solar cell 111 by soldering, the connecting conductor 113 is mounted on a bus bar electrode 112 of the solar cell 111. The hot air blast blowing nozzle 116 for soldering is then positioned at the upper part of one end of the bus bar electrode 112 of the solar cell 111. The hot air blast blowing nozzle 116 is then moved from one end of the bus bar electrode 112 of the solar cell 111 to the other end while blowing hot air. This means that compared to up until now where the connecting conductors 113 on the electrodes have been soldered at substantially the same time over the whole of this region, portions to be soldered can be moved consecutively from one end of the bus bar electrode 112 of the solar cell 111 to the other end using apparatus of a simpler structure, and it is also possible for differences in thermal contraction due to differences in thermal expansion coefficients of the material for the solar cells 111 and the connecting conductors 113 during heating using hot air at the time of soldering to be absorbed. At the solar cell 111 after the connecting conductor 113 is fitted, warping no longer occurs, the electrodes of the solar cell 111 do not peel away from the substrate of the solar cell 111, and fracturing and cracking no longer occurs for the solar cells 111 in subsequent solar cell module processes.

Fig. 20 shows a further example of solar cell module producing apparatus of the present invention where connecting conductors are soldered to a solar cell.

Here, the connecting conductors 113 are mounted on the bus bar electrodes 112 of the solar cell 111 and the connecting conductors 113 are pressed on at both ends of the bus bar electrodes 112 by pressing pins 117a and 117b so as to be fixed. Two hot air blast blowing nozzles 116a and 116b are located above the substantial center of the bus bar electrodes and move in opposite directions towards the ends of the bus bar electrodes 112.

Namely, with solar cell module manufacturing apparatus for fitting the connecting conductors 113 for electrically connecting the solar cell 111 to the bus bar electrodes 112 of the solar cell 111 by soldering, the connecting conductor 113 is mounted on a bus bar electrode 112 of the solar cell 111. A plurality of hot air blow holes for soldering are then provided above the substantial center of the bus bar electrode 112 of the solar cell 111. The hot air blow holes are then moved in directions towards both ends of the bus bar electrode 112 of the solar cell 111 while blowing hot air from the plurality of hot air blow holes. Warping therefore no longer occurs and the time for soldering the connecting conductor 113 can be made shorter.

### INDUSTRIAL APPLICABILITY

The solar cell module of the first embodiment of the present invention has a structure where the plane shape of at least one end of the connecting conductors is provided with a plurality of angled sections that are obtuse angles. This means that even if thermal contraction of the connecting conductors occurs during soldering on the electrodes of the solar cells, stress due to the thermal contraction at the angled sections of the ends is not concentrated and the likelihood of the occurrence of cracks in the solar cells can be made small.

Further, with a solar cell module of a further embodiment of the present invention, a plane shape of at least one end of the connecting conductors has a structure including a peripheral edge that curves in a manner extending outwards. This means that even if thermal contraction of the connecting conductor occurs during soldering onto the electrodes of the solar cell, it is possible for stress to be uniformly distributed and more reliable apparatus can therefore be achieved.

Moreover, with a solar cell module of a still further embodiment of the present invention, a through-hole is provided at at least one end of the connecting conductors. This means that even if connection tabs thermally contract during soldering onto the electrodes of the solar cells the stress is not concentrated at the angled portions of the ends, stress at the through-holes can be distributed, and the likelihood of cracks occurring at the solar elements is reduced.

## Claims

1. A solar cell module comprising:
solar cells formed with electrodes; and
ribbon-shaped connecting conductors connected to the electrodes using solder;
wherein a plane shape of at least one end of the connecting conductors has a plurality of angled sections with obtuse angles.

2. A solar cell module comprising:
solar cells formed with electrodes; and
ribbon-shaped connecting conductors connected to the electrodes using solder;
wherein a plane shape of at least one end of the connecting conductors includes a peripheral edge made from a curve extending outwards.

3. The solar cell module as disclosed in claim 2, wherein the curve is a circular arc.

4. A solar cell module comprising:
solar cells formed with electrodes; and
ribbon-shaped connecting conductors connected to the electrodes using solder;
wherein the connecting conductors have a through-hole at at least one end.

5. The solar cell module as disclosed in any one of claims 1 to 4, wherein the end(s) is(are) thinner than other portions of the connecting conductor.

6. The solar cell module as disclosed in claim 5, wherein the end(s) is(are) thinner as a result of pressing.
